# EUROPEAN PATENT APPLICATION

(11) **EP 2 415 592 A1**
(43) Date of publication of application: **08.02.2012**
(21) Application number: 10758532.5
(22) Date of filing: 25.03.2010
(51) Int. Cl.: B32B 7/12, B81B 7/02, B81C 3/00, C09J 4/02, C09J 7/02, C09J 133/02, C09J 163/10, C09J 179/08, C09J 201/00, H01L 23/10, H01L 31/02

(54) **FILM FOR RESIN SPACER, LIGHT-RECEIVING DEVICE AND METHOD FOR MANUFACTURING SAME, AND MEMS DEVICE AND METHOD FOR MANUFACTURING SAME**

(30) Priority: 31.03.2009 JP 2009084692
(71) Applicant: Sumitomo Bakelite Co., Ltd., Shinagawa-ku Tokyo 140-0002 (JP)
(72) Inventor: DEJIMA, Hirohisa, Tokyo 140-0002 (JP); KAWATA, Masakazu, Tokyo 140-0002 (JP); YONEYAMA, Masahiro, Tokyo 140-0002 (JP); TAKAHASHI, Toyosei, Tokyo 140-0002 (JP); SHIRAISHI, Fumihiro, Tokyo 140-0002 (JP); SATO, Toshihiro, Tokyo 140-0002 (JP)
(74) Representative: Grünecker, Kinkeldey, Stockmair & Schwanhäusser
(86) International application number: PCT/JP2010/055237
(87) International publication number: WO 2010/113759

(57) **Abstract**

According to one aspect of the present invention, a film for a resin spacer (10) comprises an adhesive layer (12) made of a resin composition and a cover film (14) covering a surface of the adhesive layer (12). In the above-described film for a resin spacer (10), an adhesion force C₁ between the adhesive layer (12) and the cover film (14) and an adhesion force D between the adhesive layer (12) and a silicone resin are set so as to satisfy the condition C₁ > D. Consequently, it is possible to reduce resin adherence to a cutting table at the time of cutting the film for a resin spacer (10).

## Description

### {Technical Field}

The present invention relates to a film for a resin spacer, a light-receiving device, a method for manufacturing the light-receiving device, a MEMS device, and a method for manufacturing the MEMS device. More particularly, the present invention relates to a film for a resin spacer used in the manufacture of a light-receiving device and a MEMS device, a light-receiving device using the film, a method for manufacturing the light-receiving device, a MEMS device, and a method for manufacturing the MEMS device.

### {Background Art}

In recent years, a light-receiving device equipped with a light-receiving element, such as a CCD or a CMOS, is widely used in the field of optical equipment, including mobile phones and digital still cameras.

Such a light-receiving device is required to have a structure in which the light-receiving element is hermetically housed, in order to prevent such foreign matter as dust or contamination, which can be a cause for imaging failure, from getting inside the light-receiving device. Accordingly, a commonly-used light-receiving device has a hollow package structure in which a base substrate including a light-receiving element formed therein and a transparent substrate disposed oppositely to the base substrate are bonded to each other through a spacer.

Spacers made of various materials have been proposed as spacers used to form a hollow package structure. Among these spacers, a resin spacer is a focus of attention since a light-receiving device having a hollow package structure can be manufactured at low costs.

For example, Patent Literature 1 discloses a method for manufacturing a light-receiving device having a hollow package structure by using an adhesive film in which a photosensitive resin composition is covered with a cover film. In this method, the adhesive film is laminated on a wafer in which a photoelectric conversion part including a CCD circuit or a CMOS circuit is formed. Thereafter, the adhesive film is exposed and developed, thereby forming a resin spacer surrounding the photoelectric conversion part of the wafer. Then, a transparent substrate is bonded to the resin spacer formed on the wafer, thereby obtaining a light-receiving device having a hollow package structure in which the photoelectric conversion part is hermitically sealed with the wafer, the resin spacer and the transparent substrate.

In addition, a resin spacer has the advantage of being inexpensive, lightweight, and so on. Accordingly, the resin spacer not only is used when manufacturing a light-receiving device having a hollow package structure, but also is taking the place of spacers made of a variety of other materials in various applications.

For example, Patent Literature 2 discloses a method for manufacturing a MEMS (Micro Electro Mechanical Systems) device by using a photosensitive resin film (film for a resin spacer). In this method, the photosensitive resin film is laminated on a wafer in which a MEMS element is formed. Thereafter, the photosensitive resin film is exposed and developed, thereby manufacturing a MEMS device having a structure in which the MEMS element is surrounded by the resin spacer.

### {Citation List}

### {Patent Literature}

{PTL 1}: Japanese Patent Application Laid-Open No. 2008-42186
{PTL 2}: Japanese Patent Application Laid-Open No. 2007-189032

### {Summary of Invention}

### {Technical Problem}

When a light-receiving device or a MEMS device is manufactured using a film for a resin spacer, as in the methods disclosed in Patent Literatures 1 and 2, the film for a resin spacer is, in some cases, previously cut in conformity to the shape of a wafer before the film is laminated thereon.

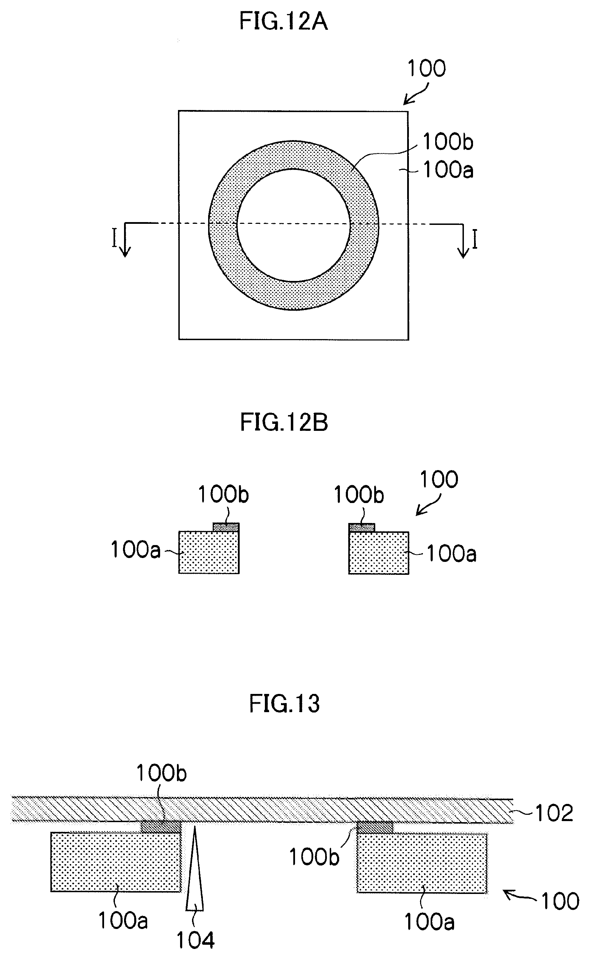

Figure 12A is a plan view illustrating one example of a cutting table used to cut a film for a resin spacer, whereas Figure 12B is a cross-sectional view taken along the line I-I of the cutting table illustrated in Figure 12A. In addition, Figure 13 is a cross-sectional view illustrating the way the film for a resin spacer is cut using the cutting table illustrated in Figures 12A and 12B.

As illustrated in Figures 12A and 12B, a cutting table 100 comprises a stage section 100a in the central portion of which an opening is provided, and a film contact part 100b provided on the stage section 100a so as to surround the opening. As illustrated in Figure 13, a film for a resin spacer 102 is placed on the film contact part 100b of the cutting table 100 at the time of film cutting. Then, the film is cut by a cutter 104 provided in the opening of the cutting table 100.

In cases where the film for a resin spacer is cut in this way, the inventors of the present application have recognized the following problems.

That is, the inventors have recognized that in some cases, part of a resin composition of the film for a resin spacer adheres to the film contact part of the cutting table at the time of the above-described film cutting, thus adversely affecting the accuracy of subsequent film cutting.

In addition, a keen examination made by the inventors has revealed that the adherence of the resin composition to the cutting table at the time of film cutting can occur even if a silicone resin excellent in mold releasability is used as the film contact part.

The present invention has been accomplished in view of such circumstances as described above. Accordingly, an object of the present invention is to provide a film for a resin spacer capable of reducing the adherence of a resin composition to a cutting table at the time of film cutting, a light-receiving device using the film, a method for manufacturing the light-receiving device, a MEMS device, and a method for manufacturing the MEMS device.

### {Solution to Problem}

One aspect of the present invention relates to a film for a resin spacer, the film including an adhesive layer made of a resin composition; and a cover film covering a surface of the adhesive layer, wherein an adhesion force C₁ between the adhesive layer and the cover film and an adhesion force D between the adhesive layer and a silicone resin satisfy the condition C₁ > D.

In this aspect, the adhesion force C₁ between the adhesive layer of the film for a resin spacer and the cover film and the adhesion force D between the adhesive layer of the film for a resin spacer and the silicone resin, which is a typical material of the film contact part of the cutting table, are set so as to satisfy the condition C₁ > D. An examination made by the inventors of the present application has revealed that according to the above-described aspect, it is possible to reduce adherence of the resin composition to the film contact part for various materials thereof, without limitation to cases in which a material constituting the film contact part of the cutting table is a silicone resin.

Here, the phrase "adhesion force" refers to a force per unit width necessary to vertically separate two dissimilar substances at the boundary face thereof and, specifically, refers to a peel strength at 25°C. In addition, the "silicone resin" used to measure the adhesion force D is specifically a composite silicone sheet (made by Nippa Co., Ltd.).

In the film for a resin spacer according to the above-described aspect, an adhesion force E₁ between the adhesive layer and a silicon wafer preferably satisfies the condition E₁ > 0.01 N/m.

If the adhesion force E₁ between the adhesive layer of the film for a resin spacer and a silicon wafer, which is a typical example of a substrate to be laminated with the film for a resin spacer, satisfies the condition E₁ > 0.01 N/m, as described above, the film for a resin spacer can be reliably fixed onto the substrate to be laminated.

Here, the "silicon wafer" used to measure the adhesion force E₁ is specifically a polished wafer (made by SUMCO Corporation; Part No. PW, 725 µm in thickness).

In the film for a resin spacer according to the above-described aspect, an adhesion force C₂ between the adhesive layer and the cover film after exposure on the i-line based cumulative light exposure condition of 700 mJ/cm² and an adhesion force E₂ between the adhesive layer and the silicon wafer after exposure on the i-line based cumulative light exposure condition of 700 mJ/cm² preferably satisfy the condition C₂ < E₂.

Here, the "silicon wafer" used to measure the adhesion force E₂ is specifically a polished wafer (made by SUMCO Corporation; Part No. PW, 725 µm in thickness).

If the adhesion force C₂ between the adhesive layer and the cover film after exposure and the adhesion force E₂ between the adhesive layer and the silicon wafer after exposure, which is a typical example of the substrate to be laminated, satisfy the condition C₂ < E₂, as described above, it is possible to reduce adherence of the resin composition to the cover film when peeling off the cover film after the exposure of the film for a resin spacer on the substrate to be laminated.

Here, the phrase "i-line based cumulative light exposure" refers to a value obtained by integrating the luminance of i-line light (near a wavelength of 365 nm) used for exposure by exposure time.

In addition, the phrase "i-line based cumulative light exposure of 700 mJ/cm²" assumes common exposure conditions applied when a resin spacer of a light-receiving device or a MEMS device is formed.

In the film for a resin spacer according to the above-described aspect, the elastic modulus of the adhesive layer after exposure on the i-line based cumulative light exposure condition of 700 mJ/cm² is preferably 100 Pa or higher at a measurement temperature of 80°C.

Using such a film for a resin spacer as described above, it is possible to form a resin spacer less susceptible to resin spacer deformation and superior in shape retainability when a cover substrate and the silicon wafer are bonded to each other through the resin spacer, since the elastic modulus of the adhesive layer after exposure is sufficiently high.

In the film for a resin spacer according to the above-described aspect, the moisture permeation rate of the adhesive layer after exposure on the i-line based cumulative light exposure condition of 700 mJ/cm² and heat curing on the condition of 180°C and 2 hours measured by a JIS Z0208 B method is preferably 12 g/m²/24 h or higher.

Using such a film for a resin spacer as described above, it is possible to release moisture within a hollow package of a light-receiving device or a MEMS device to the outside since the moisture permeation rate of the adhesive layer after exposure and heat curing is sufficiently high. Thus, it is possible to form a resin spacer capable of reducing dew condensation in the light-receiving device or the MEMS device.

In the film for a resin spacer according to the above-described aspect, the resin composition preferably contains an alkali-soluble resin and a photopolymerizable resin.

If the resin composition constituting the adhesive layer of the film for a resin spacer contains a photopolymerizable resin, as described above, it is possible to precisely form a resin spacer by a photolithographic technique. In addition, if the resin composition contains an alkali-soluble resin, it is possible to perform the development treatment of the film for a resin spacer by using an alkaline water solution having a small environmental load.

The resin composition may further contain a thermosetting resin.

If the resin composition contains a thermosetting resin, in addition to an alkali-soluble resin and a photopolymerizable resin, it is possible to not only form a resin spacer superior in heat resistance but also reliably bond the resin spacer and the substrate to each other by means of thermocompression bonding after the formation of the resin spacer.

The alkali-soluble resin may contain a (meth)acrylic modified novolac resin.

If the alkali-soluble resin contains a (meth)acrylic modified novolac resin, as described above, it is possible to improve the compatibility of the photopolymerizable resin and the thermosetting resin with each other.

The alkali-soluble resin may contain a carboxyl group-containing polymer selected from the group consisting of a carboxyl group-containing epoxy acrylate, a carboxyl group-containing acrylic polymer, and polyamide acid.

The photopolymerizable resin may contain an acrylic monomer.

If an acrylic monomer is used as the photopolymerizable resin, it is possible to suitably use a trifunctional (meth)acrylate compound, a tetrafunctional (meth)acrylate compound, or the like, superior in photopolymerizability.

The photopolymerizable resin may contain a (meth)acrylic acid adduct of an epoxy compound.

Another aspect of the present invention relates to a light-receiving device including: a base substrate in which a photoelectric conversion part is formed; a transparent substrate disposed so as to face the base substrate; and a resin spacer disposed between the base substrate and the transparent substrate so as to surround the photoelectric conversion part, wherein the resin spacer is formed of a film for a resin spacer according to the above-described aspect.

Yet another aspect of the present invention relates to a MEMS device including: a base substrate in which a functional part including a MEMS element is formed; a cover substrate disposed so as to face the base substrate; and a resin spacer disposed between the base substrate and the cover substrate so as to surround the functional part, wherein the resin spacer is formed of a film for a resin spacer according to the above-described aspect.

Still another aspect of the present invention relates to a method for manufacturing a light-receiving device, the method including: a film cutting step of cutting a film for a resin spacer according to the above-described aspect; a laminating step of laminating the film for a resin spacer cut in the film cutting step on a surface of a wafer in which a plurality of photoelectric conversion parts is formed; an exposure/development step of exposing and developing the film for a resin spacer laminated on the wafer, so that a resin spacer surrounding the plurality of photoelectric conversion parts is formed; a bonding step of bonding the wafer and the transparent substrate through the resin spacer formed in the exposure/development step; and a dividing step of dividing the wafer and the transparent substrate bonded through the resin spacer in units of photoelectric conversion parts.

Still another aspect of the present invention relates to a method for manufacturing a light-receiving device, the method including: a film cutting step of cutting a film for a resin spacer according to the above-described aspect; a laminating step of laminating the film for a resin spacer cut in the film cutting step on a surface of a transparent substrate; an exposure/development step of exposing and developing the film for a resin spacer laminated on the transparent substrate, so that a resin spacer is formed on the transparent substrate; a bonding step of bonding a wafer in which a plurality of photoelectric conversion parts is formed and the transparent substrate through the resin spacer formed in the exposure/development step, so that the plurality of photoelectric conversion parts is surrounded by the resin spacer; and a dividing step of dividing the wafer and the transparent substrate bonded through the resin spacer in units of photoelectric conversion parts.

Still another aspect of the present invention relates to a method for manufacturing a MEMS device, the method including: a film cutting step of cutting a film for a resin spacer according to the above-described aspect; a laminating step of laminating the film for a resin spacer cut in the film cutting step on a surface of a wafer in which a functional part including a MEMS element is formed; an exposure/development step of exposing and developing the film for a resin spacer laminated on the wafer, so that a resin spacer surrounding the functional part is formed; and a bonding step of bonding the wafer and a cover substrate through the resin spacer formed in the exposure/development step.

Still another aspect of the present invention relates to a method for manufacturing a MEMS device, the method including: a film cutting step of cutting a film for a resin spacer according to the above-described aspect; a laminating step of laminating the film for a resin spacer cut in the film cutting step on a surface of a cover substrate; an exposure/development step of exposing and developing the film for a resin spacer laminated on the cover substrate, so that a resin spacer is formed on the cover substrate; and a bonding step of bonding a wafer in which a functional part including a MEMS element is formed and the cover substrate through the resin spacer formed in the exposure/development step, so that the functional part is surrounded by the resin spacer.

### {Advantageous Effects of Invention}

According to the present invention, it is possible to prevent the adherence of a resin composition to a cutting table at the time of film cutting by setting an adhesion force C₁ between an adhesive layer of a film for a resin spacer and a cover film and an adhesion force D between the adhesive layer of the film for a resin spacer and a silicone resin so as to satisfy the condition C₁ > D.

### {Brief Description of Drawings}

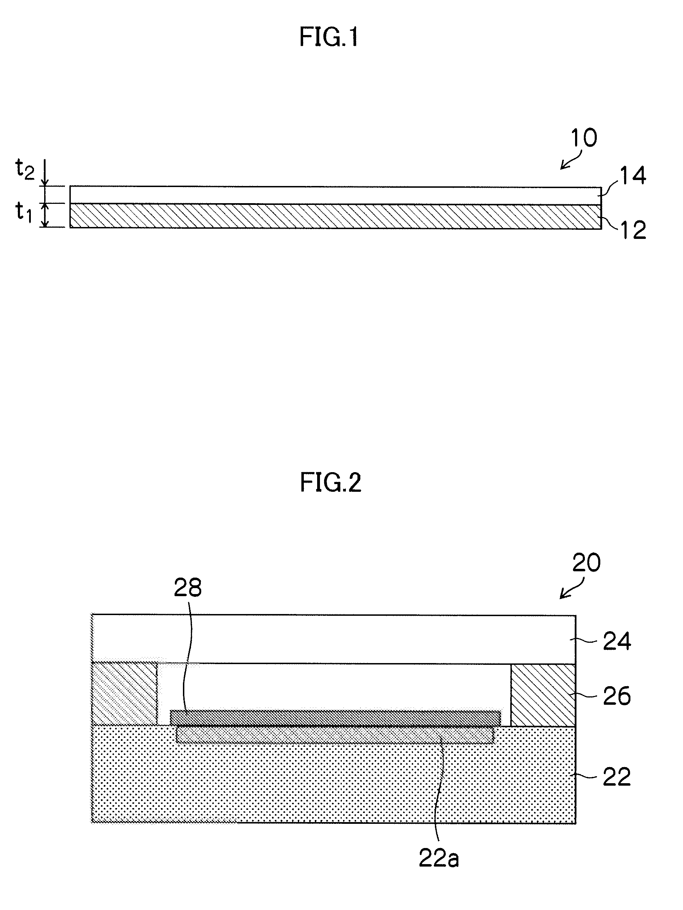

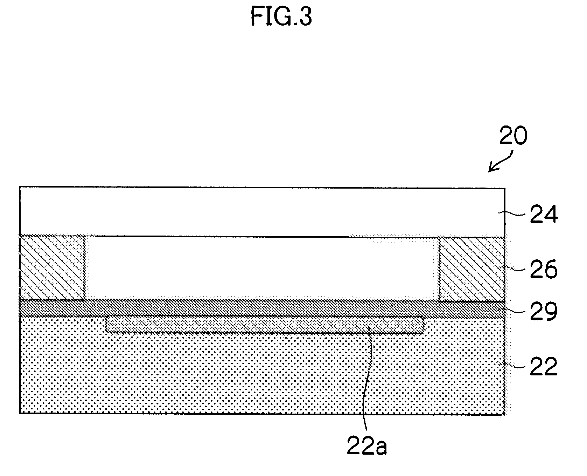

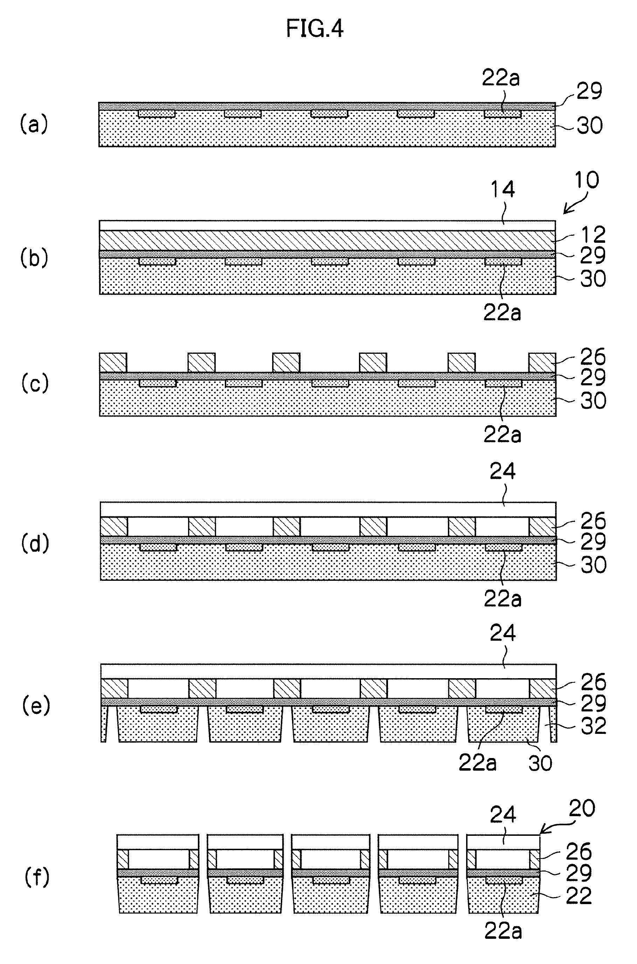

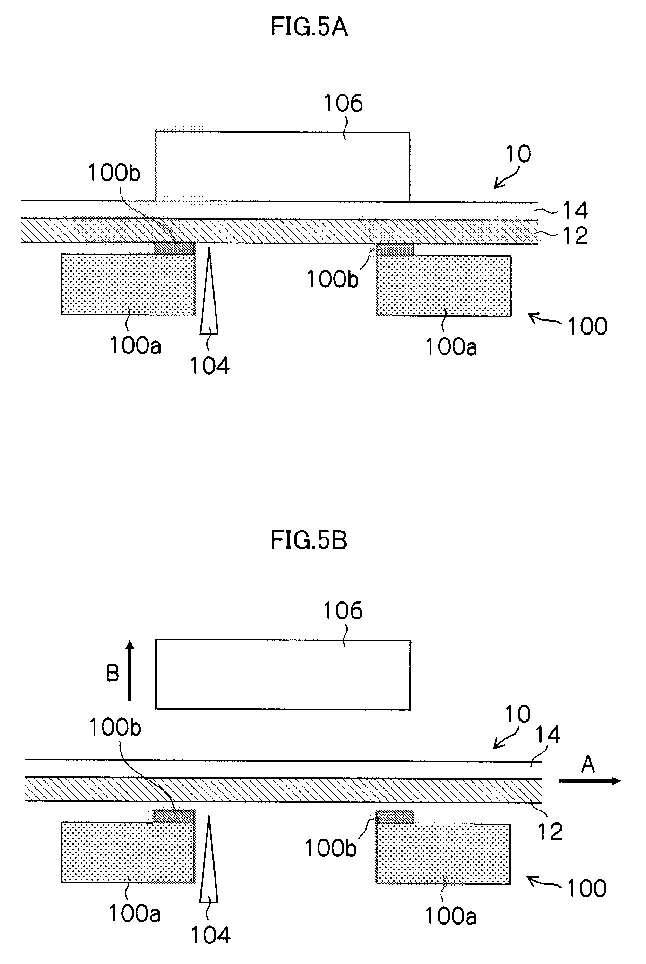

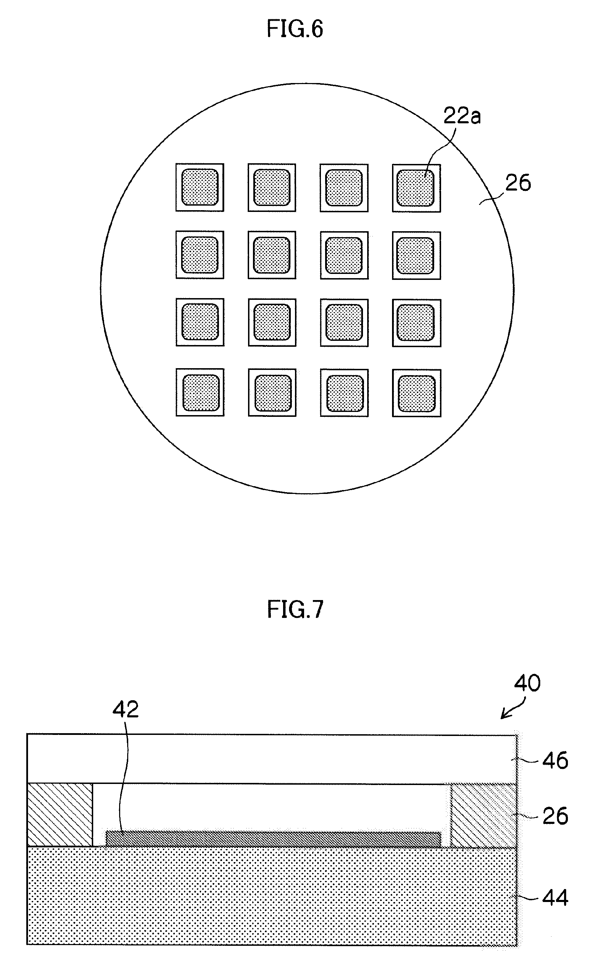

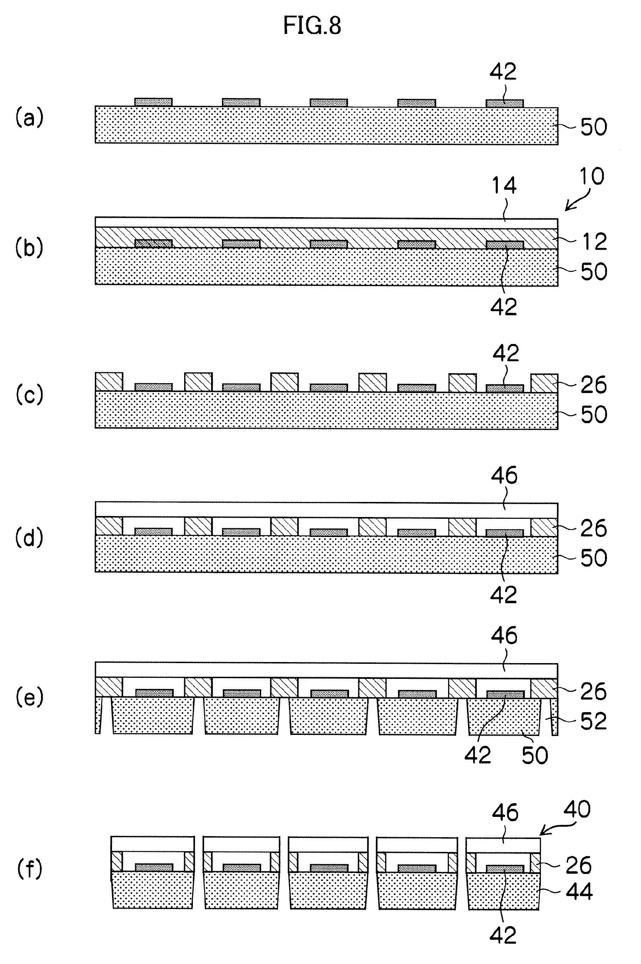

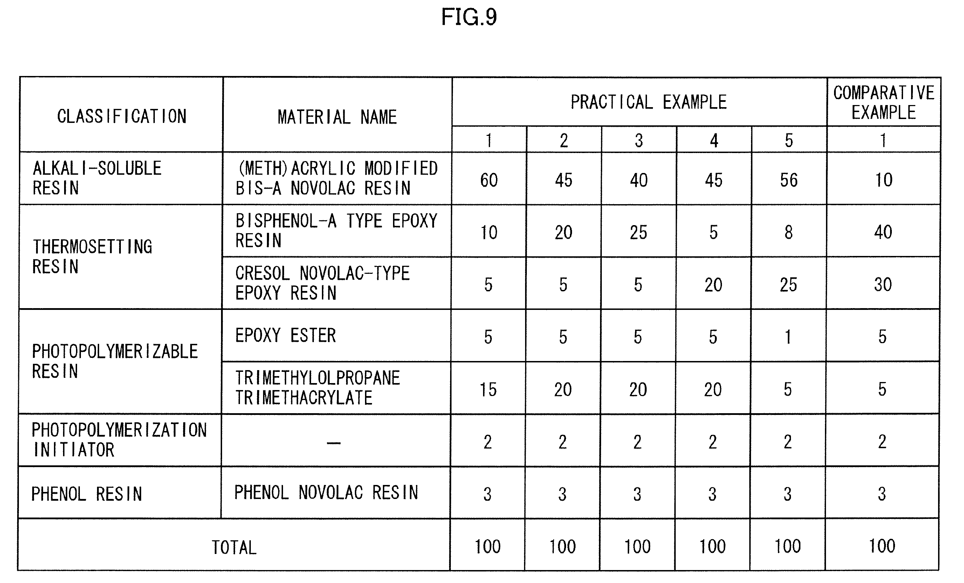

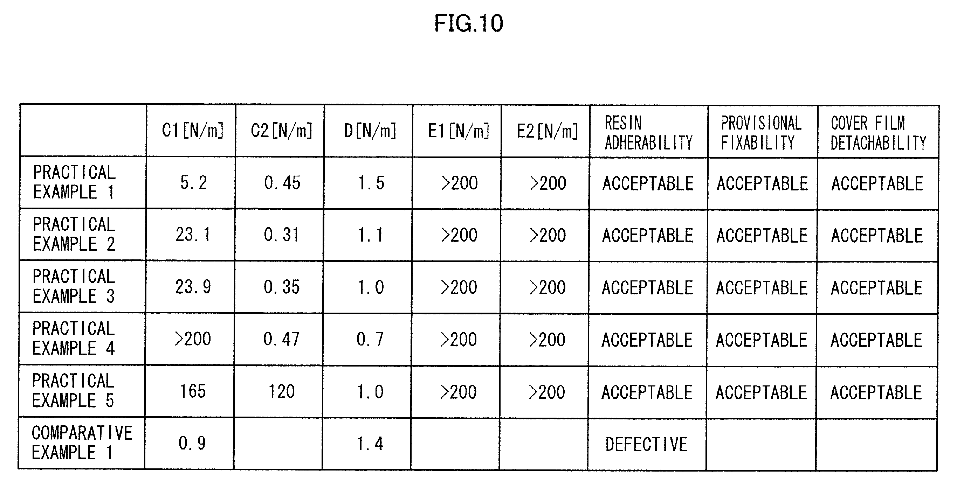

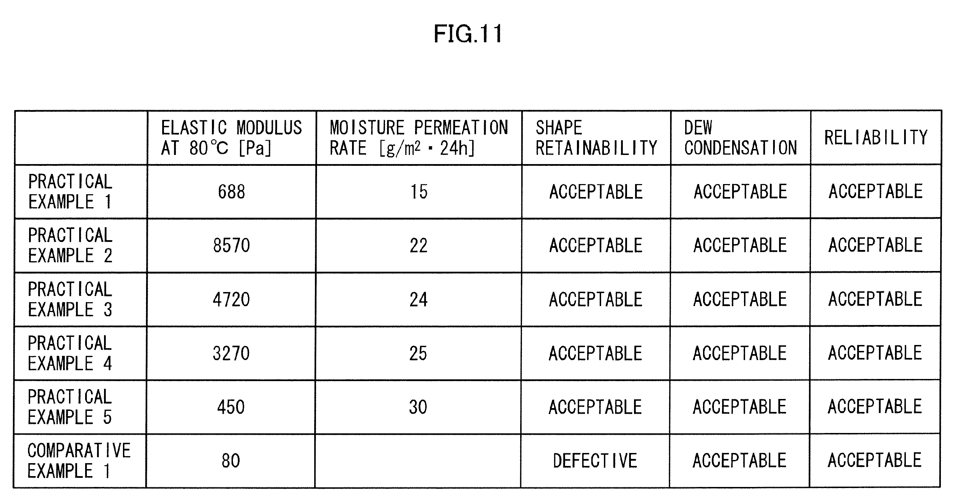

{Figure 1} Figure 1 is a cross-sectional view illustrating a structural example of a film for a resin spacer according to the present invention.
{Figure 2} Figure 2 is a cross-sectional view illustrating a structural example of a light-receiving device according to the present invention.
{Figure 3} Figure 3 is a cross-sectional view illustrating another structural example of the light-receiving device according to the present invention.
{Figure 4} Figure 4 is a process drawing illustrating one example of a method for manufacturing a light-receiving device according to the present invention.
{Figure 5A} Figure 5A is a drawing illustrating the way a film for a resin spacer is cut.
{Figure 5B} Figure 5B is a drawing illustrating the way the film for a resin spacer is conveyed after being cut.
{Figure 6} Figure 6 is a plan view illustrating one example of a resin spacer formed by an exposure/development treatment.
{Figure 7} Figure 7 is a cross-sectional view illustrating a structural example of a MEMS device according to the present invention.
{Figure 8} Figure 8 is a process drawing illustrating one example of a method for manufacturing a MEMS device according to the present invention.
{Figure 9} Figure 9 is a table showing ingredient amounts of a film for a resin spacer in Practical Examples 1 to 5 and Comparative Example 1.
{Figure 10} Figure 10 is a table showing measurement results in Practical Examples 1 to 5 and Comparative Example 1.
{Figure 11} Figure 11 is another table showing measurement results in Practical Examples 1 to 5 and Comparative Example 1.
{Figure 12A} Figure 12A is a plan view illustrating a structural example of a cutting table.
{Figure 12B} Figure 12B is a cross-sectional view taken along the line I-I of the cutting table illustrated in Figure 12A.
{Figure 13} Figure 13 is a drawing illustrating the way a film for a resin spacer is cut using the cutting table illustrated in Figures 12A and 12B.

### {Description of Embodiments}

Hereinafter, embodiments of the present invention will be described with reference to the accompanying drawings.

First, a description will be given of a configuration of a film for a resin spacer according to the present invention. Then, a description will be given of a resin composition constituting an adhesive layer of this film for a resin spacer. Thereafter, a description will be given of a light-receiving device using the film for a resin spacer, a method for manufacturing the light-receiving device, a MEMS device, and a method for manufacturing the MEMS device.

### (Film for Resin Spacer)

Figure 1 is a cross-sectional view illustrating a structural example of a film for a resin spacer according to the present invention.

As illustrated in the figure, a film for a resin spacer 10 comprises an adhesive layer 12 made of a resin composition, and a cover film 14 covering one surface of the adhesive layer 12.

The resin composition constituting the adhesive layer 12 preferably has alkali developability, photosensitivity and thermosettability by containing an alkali-soluble resin, a photopolymerizable resin and a thermosetting resin, as will be described later.

A film thickness t₁ of the adhesive layer 12 is preferably set to an appropriate range, according to the purpose of use of a light-receiving device or a MEMS device. For example, if the film for a resin spacer 10 is used in the manufacture of a light-receiving device, the film thickness t₁ of the adhesive layer 12 can be set to 5 µm or larger but not larger than 100 µm.

A material constituting the cover film 14 is not limited in particular, as long as the material has film characteristics (for example, rupture strength and flexibility) capable of maintaining a film state of the adhesive layer 12. As the material, it is possible to use, for example, polyethylene terephthalate (PET), polypropylene (PP), polyethylene (PE), or polyester.

In addition, a film thickness t₂ of the cover film 14 is preferably adjusted as appropriate, to the extent that the strength and handleability of the film for a resin spacer 10 are compatible with each other.

In the film for a resin spacer 10 having the above-described configuration, an adhesion force C₁ between the adhesive layer 12 and the cover film 14 before exposure and an adhesion force D between the adhesive layer 12 and a silicone resin before exposure are set so as to satisfy the condition C₁ > D (preferably, C₁ > 3D). Here, the reason for setting the condition including the adhesion force D between the adhesive layer 12 and the silicone resin as an element of the condition is that a silicone resin is assumed as a typical material used as the film contact part of the cutting table.

If the adhesion force C₁ and the adhesion force D satisfy the condition C₁ > D, it is possible to reduce adherence of the resin composition to the film contact part for various materials thereof, without limitation to cases in which a material constituting the film contact part of the cutting table is a silicone resin. In particular, if the adhesion force C₁ and the adhesion force D satisfy the condition C₁ > 3D, it is possible to more reliably reduce adherence of the resin composition to the film contact part.

Examples of a method for adjusting the adhesion force C₁ and the adhesion force D so as to satisfy the condition C₁ > D (preferably, C₁ > 3D) also include appropriately adjusting the structures, the compounding ratio and the like of an alkali-soluble resin, a photopolymerizable resin and a thermosetting resin, in addition to appropriately selecting a material of the cover film and a mold-releasing agent on a surface of the cover film.

An adhesion force E₁ between the adhesive layer 12 and a silicon wafer before exposure as a typical example of a substrate to be laminated with the film for a resin spacer 10 preferably satisfies the condition E₁ > 0.01 N/m and, more preferably, satisfies the condition E₁ > 200 N/m.

If the adhesion force E₁ between the adhesive layer 12 and the silicon wafer as a typical example of a substrate to be laminated satisfies the above-described condition, the film for a resin spacer 10 can be reliably fixed onto the substrate to be laminated (for example, a silicon wafer).

Examples of a method for adjusting the adhesion force E₁ so as to satisfy the condition E₁ > 0.01 N/m include appropriately adjusting the structures, the compounding ratio and the like of an alkali-soluble resin, a photopolymerizable resin and a thermosetting resin.

In addition, the adhesion force C₂ between the adhesive layer 12 on the i-line based cumulative light exposure condition of 700 mJ/cm² and the cover film 14 after exposure and the adhesion force E₂ between the adhesive layer 12 on the i-line based cumulative light exposure condition of 700 mJ/cm² and a silicon wafer after exposure, which is a typical example of the substrate to be laminated, preferably satisfy the condition C₂ < E₂.

If the adhesion force C₂ and the adhesion force E₂ satisfy the above-described condition, it is possible to reduce adherence of the resin composition to the cover film 14 when exposing the film for a resin spacer 10 laminated on the substrate to be laminated (for example, a silicon wafer) and peeling off the cover film 14 from the adhesive layer 12.

Examples of a method for adjusting the adhesion forces C₂ and E₂ so as to satisfy the condition C₂ < E₂ include appropriately adjusting the structures of a photopolymerization initiator and a photopolymerizable resin and the compounding ratio of an alkali-soluble resin, a photopolymerizable resin and a thermosetting resin.

In addition, the elastic modulus of the adhesive layer 12 after exposure on the i-line based cumulative light exposure condition of 700 mJ/cm² is preferably 100 Pa or higher at a measurement temperature of 80°C.

If the elastic modulus of the adhesive layer 12 after exposure is as sufficiently high as described above, it is possible to form a resin spacer superior in shape retainability.

Examples of a method for adjusting the elastic modulus of the adhesive layer 12 to 100 Pa or higher include appropriately adjusting the structure of a photopolymerizable resin and the structures of and the compounding ratio of an alkali-soluble resin, a photopolymerizable resin and a thermosetting resin.

In addition, the moisture permeation rate of the adhesive layer 12 measured by a JIS Z0208 B method after exposure on the i-line based cumulative light exposure condition of 700 mJ/cm² and heat curing on the condition of 180°C and 2 hours is preferably 12 g/m²/24 h or higher.

If the moisture permeation rate of the adhesive layer after exposure and heat curing is as sufficiently high as described above, it is possible to form a resin spacer capable of reducing dew condensation within a hollow package of a light-receiving device or a MEMS device.

Examples of a method for adjusting the above-described moisture permeation rate of the adhesive layer 12 to 12 g/m²/24 h or higher include appropriately adjusting the structure of a thermosetting resin and the structures and the compounding ratio of an alkali-soluble resin, a photopolymerizable resin and a thermosetting resin.

### (Resin Composition Constituting Adhesive Layer)

Next, a description will be given of a resin composition constituting the adhesive layer 12 of the film for a resin spacer 10.

The resin composition of the adhesive layer 12 preferably has alkali developability, photosensitivity and thermosettability by containing an alkali-soluble resin, a photopolymerizable resin and a thermosetting resin.

If the resin composition constituting the adhesive layer 12 contains a photopolymerizable resin as described above, it is possible to precisely form a resin spacer by a photolithographic technique. In addition, if the resin composition constituting the adhesive layer 12 contains an alkali-soluble resin, it is possible to perform a development treatment by using an alkaline water solution having a small environmental load. Yet additionally, if the resin composition constituting the adhesive layer 12 contains a thermosetting resin, it is possible to not only form a resin spacer superior in heat resistance but also reliably bond the resin spacer and a substrate to each other by means of thermocompression bonding after the formation of the resin spacer.

Hereinafter, a description will be given of details on resin compositions constituting the adhesive layer 12, in the order of an alkali-soluble resin, a photopolymerizable resin and a thermosetting resin.

Examples of an alkali-soluble resin that can be contained in the resin composition of the adhesive layer 12 may include a carboxyl group-containing polymer selected from the group consisting of a carboxyl group-containing epoxy acrylate, a carboxyl group-containing acrylic polymer, and polyamide acid, novolac resins of cresol type, phenol type, bisphenol-A type, bisphenol-F type, catechol type, resorcinol type, pyrogallol type and the like, (meth)acrylic modified novolac resins such as a (meth)acrylic modified bisphenol-A type novolac resin, a copolymer of styrene and acrylic acid, a polymer of hydroxystyrene, polyvinyl phenol, poly alpha-methylvinyl phenol, a phenol aralkyl resin, a (meth)acrylic acid resin, an acrylic resin such as a (meth)acrylic acid ester resin, a cyclic olefin-based resin containing a hydroxyl group, a carboxyl group or the like, and polyamide resins (specifically, a resin having at least one of a polybenzoxazole structure and a polyimide structure and including a hydroxyl group, a carboxyl group, an ether group or an ester group in a main chain or side chain, a resin having a polybenzoxazole precursor structure, a resin having a polyimide precursor structure, a resin having a polyamide acid ester structure, and the like).

Among these examples, a (meth)acrylic modified novolac resin is preferable in that the resin can be development-treated by using an alkaline water solution having a small environmental load and that the heat resistance of a resin spacer can be improved.

As the alkali-soluble resin to be contained in the resin composition of the adhesive layer 12, alkali-soluble resins of a plurality of types may be used in combination.

In addition, the content ratio of the alkali-soluble resin in the resin composition is not limited in particular, but is preferably 50 to 95 wt. % of the resin composition constituting the adhesive layer 12. If the content ratio of the alkali-soluble resin is lower than the above-described lower limit, it may not be possible to fully attain the effect of improving compatibility between a photocurable resin and a thermosetting resin. On the other hand, if the content ratio of the alkali-soluble resin is higher than the above-described upper limit, the developability or pattern resolution of the adhesive layer 12 may not be sufficient.

Examples of a photopolymerizable resin that can be contained in the resin composition of the adhesive layer 12 may include a (meth)acrylic acid adduct of an epoxy compound and an acrylic monomer of a (meth)acrylate compound or the like.

Among these examples, a polyfunctional acrylic monomer having a trifunctional or higher functional group is preferable, and a trifunctional (meth)acrylate compound or a tetrafunctional (meth)acrylate compound is more preferable. If a polyfunctional acrylic monomer is used, it is possible to improve the mechanical strength of a resin spacer after exposure and development.

As the polyfunctional acrylic monomer, it is possible to use, for example, a trifunctional (meth)acrylate such as a trimethylolpropane tri(meth)acrylate or a pentaerythritol tri(meth)acrylate, a tetrafunctional (meth)acrylate such as a pentaerythritol tetra(meth)acrylate or a ditrimethylolpropane tetra(meth)acrylate, or a hexafunctional (meth)acrylate such as a dipentaerythritol hexa(meth)acrylate.

If a polyfunctional acrylic monomer is used as the photopolymerizable resin, the content ratio of the polyfunctional acrylic monomer in the resin composition is not limited in particular, but is preferably 1 to 50 wt. %, and particularly preferably, 5% to 25 wt. % of the resin composition constituting the adhesive layer 12. If the content ratio of the polyfunctional acrylic monomer is lower than the above-described lower limit, the strength of the resin spacer after exposure and development may not be sufficient. On the other hand, if the content ratio of the polyfunctional acrylic monomer exceeds the above-described upper limit, it may be difficult to thermocompression-bond a substrate through the resin spacer.

As the photopolymerizable resin, the above-described acrylic monomer may be used in combination with an epoxy vinyl ester resin. Consequently, the epoxy vinyl ester resin radical-polymerizes with the acrylic monomer at the time of exposure. Thus, it is possible to further improve the strength of the resin spacer. In addition, use of the epoxy vinyl ester resin improves the resolvability of unexposed portions of the adhesive layer 12 into an alkaline water solution. Thus, it is possible to reduce residues after development.

As the epoxy vinyl ester resin, it is possible to use a 2-hydroxy-3-phenoxypropyl acrylate, an EPOLIGHT 40E methacryl adduct, an EPOLIGHT 70P acrylic acid adduct, an EPOLIGHT 200P acrylic acid adduct, an EPOLIGHT 80MF acrylic acid adduct, an EPOLIGHT 3002 methacrylic acid adduct, an EPOLIGHT 3002 acrylic acid adduct, an EPOLIGHT 1600 acrylic acid adduct, a bisphenol-A diglycidyl ether methacrylic acid adduct, bisphenol-A diglycidyl ether acrylic acid adduct, an EPOLIGHT 200E acrylic acid adduct, an EPOLIGHT 400E acrylic acid adduct, or the like.

The content ratio of the epoxy vinyl ester resin in the resin composition is not limited in particular, but is preferably 3 to 30 wt.%, and more preferably, 5 to 15 wt.% of the resin composition constituting the adhesive layer 12. If the content ratio of the epoxy vinyl ester resin is lower than the above-described lower limit, the water absorbency of the resin spacer may degrade, thus causing dew condensation within a hollow package. On the other hand, if the content ratio of the epoxy vinyl ester resin is higher than the above-described upper limit, the resolvability of unexposed portions of the adhesive layer 12 into an alkaline water solution may not be sufficient. Thus, residues may be produced after development. It is possible, however, to prevent residues from being produced after development, while still maintaining the water absorbency of the resin spacer, by setting the content ratio of the epoxy vinyl ester resin to within the range of 5 to 15 wt. % in particular.

Examples of a thermosetting resin that can be contained in the resin composition of the adhesive layer 12 include novolac-type phenol resins such as a phenol novolac resin, a cresol novolac resin and a bisphenol-A novolac resin, phenol resins such a resole phenol resin, bisphenol-type epoxy resins such as a bisphenol-A epoxy resin and a bisphenol-F epoxy resin, novolac-type epoxy resins such as a novolac epoxy resin and a cresol novolac epoxy resin, epoxy resins such as a biphenyl-type epoxy resin, a stilbene-type epoxy resin, a triphenolmethane-type epoxy resin, an alkyl modified triphenolmethane-type epoxy resin, a triazine nucleus-containing epoxy resin, a dicyclopentadiene modified phenol-type epoxy resin and a silicone modified epoxy resin, a urea resin, resins having a triazine ring such as a melamine resin, an unsaturated polyester resin, a bismaleimide resin, a polyurethane resin, a diallyl phthalate resin, a silicone resin, resins having a benzoxazine ring, and a cyanate ester resin. Among these examples, it is preferable to use an epoxy resin superior in heat resistance and adhesiveness.

Here, in a case where an epoxy resin is used as the thermosetting resin, an epoxy resin in a solid state at room temperature (for example, a bisphenol-type epoxy resin) and an epoxy resin in a liquid state at room temperature (for example, a silicone modified epoxy resin) may be used concomitantly. Consequently, it is possible to realize characteristics required of the adhesive layer 12 (flexibility, pattern resolution, adhesiveness, and the like) in a balanced manner, while still maintaining the heat resistance of the resin spacer.

The content ratio of the thermosetting resin in the resin composition is not limited in particular, but is preferably 10 to 40 wt. % , and more preferably, 15 to 35 wt. % of the entire resin composition constituting the adhesive layer 12. If the content ratio of the thermosetting resin is lower than the above-described lower limit, the heat resistance of the resin spacer may not be sufficient. On the other hand, if the content ratio of the thermosetting resin is higher than the above-described upper limit, the toughness of the adhesive layer 12 may not be sufficient.

While an alkali-soluble resin, a photopolymerizable resin and a thermosetting resin have been described heretofore as main ingredients constituting the resin composition of the adhesive layer 12, the resin composition of the adhesive layer 12 may contain various other types of additives, in addition to these ingredients.

For example, a photopolymerization initiator may be added to the resin composition for the purpose of improving the pattern resolution of the adhesive layer 12.

Examples of the photopolymerization initiator include benzophenone, acetophenone, benzoin, benzoin isobutyl ether, benzoin methyl benzoate, benzoin benzoic acid, benzoin methyl ether, benzylphenyl sulfide, benzyl, dibenzyl, and diacetyl.

The content ratio of the photopolymerization initiator in the resin composition is not limited in particular, but is preferably 0.5 to 5 wt.%, and more preferably, 1 to 3 wt. % of the entire photosensitive resin composition. If the content ratio of the photopolymerization initiator is lower than the above-described lower limit, the effect of initiating a photopolymerization reaction may not be sufficient. If the content ratio of the photopolymerization initiator is higher than the above-described upper limit, the storage stability of the film for a resin spacer 10 may degrade or the pattern resolution of the adhesive layer 12 may decrease.

In addition, an auxiliary alkaline developing agent may be added to the resin composition for the purpose of improving the alkali developability of the adhesive layer 12.

Examples of the auxiliary alkaline developing agent include a phenol novolac resin, phenol aralkyl resins having a phenylene skeleton, and phenol resins such as a trisphenylmethane-type phenol resin, a biphenyl aralkyl-type phenol resin, an α-naphthol aralkyl-type phenol resin, and a β-naphthol aralkyl-type phenol resin. Among these examples, a phenol novolac resin is preferable. Consequently, it is possible to perform a development treatment using an alkaline water solution without producing residues.

The content ratio of the auxiliary alkaline developing agent in the resin composition is not limited in particular, but is preferably 1 to 20 wt.%, and more preferably, 2 to 10 wt.% of the entire resin composition of the adhesive layer 12. By setting the content ratio of the auxiliary alkaline developing agent to within the above-described range, it is possible improve alkali developability without impairing other characteristics.

In addition, an inorganic filler may be added to the resin composition for the purpose of improving characteristics, such as heat resistance, dimensional stability, and moisture resistance.

Examples of such an inorganic filler may include talc, fired clay, unfired clay, mica, silicates such as glass, a titanium oxide, alumina, oxides of silica powder such as molten silica (molten spherical silica and molten crushed silica) and crystalline silica, carbonates such as calcium carbonate, magnesium carbonate and hydrotalcite, hydroxides such as an aluminum hydroxide, a magnesium hydroxide and a calcium hydroxide, hydrosulfates or subsulfates such as a barium sulfate, a calcium sulfate and a calcium sulfite, borates such as a zinc borate, a barium metaborate, an aluminum borate, a calcium borate and a sodium borate, and nitrides such as an aluminum nitride, a boron nitride and a silicon nitride. These inorganic fillers may be used either independently or in combination. Among these examples, silica powder, such as molten silica and crystalline silica, is preferable and molten spherical silica is particularly preferable.

The content ratio of the inorganic filler in the resin composition is preferably 5 wt. % or lower from the viewpoint of reducing residues after patterning treatment.

Note that the shape of the inorganic filler is not limited in particular, but is preferably spherical. Consequently, it is possible to obtain a film for a resin spacer 10 free of anisotropy in characteristics.

The average particle diameter of the inorganic filler is not limited in particular, either, but is preferably 5 to 50 nm, and particularly preferably, 10 to 30 nm. If the average particle diameter of the inorganic filler is smaller than the above-described lower limit, the strength of the resin spacer may not be sufficient due to the presence of aggregates of the inorganic filler in the resin spacer. On the other hand, if the average particle diameter of the inorganic filler is larger than the above-described upper limit, radiant rays irradiated to the adhesive layer 12 at the time of exposure are scattered by the inorganic filler. As a result, the pattern resolution of the adhesive layer 12 may not be sufficient.

In addition to the additives described above, a plastic resin, a leveling agent, an antifoam agent, a coupling agent and the like may be added, as necessary, to the resin composition of the adhesive layer 12.

### (Light-receiving Device)

Next, a description will be given of a light-receiving device manufactured using the above-described film for a resin spacer.

Figure 2 is a cross-sectional view illustrating a structural example of a light-receiving device according to the present invention.

As illustrated in the figure, a light-receiving device 20 is comprised mainly of a base substrate 22 in which a photoelectric conversion part 22a is formed; a transparent substrate 24 disposed so as to face the base substrate 22; and a resin spacer 26 disposed between the base substrate 22 and the transparent substrate 24 so as to surround the photoelectric conversion part 22a.

The base substrate 22 is made of monocrystalline silicon or the like and, on a surface of the base substrate 22, the photoelectric conversion part 22a is formed. This photoelectric conversion part 22a is formed of a CCD (Charge Coupled Device) circuit or a CMOS (Complementary Metal Oxide Semiconductor) circuit.

A light-receiving part 28 made of a microlens array is formed on the photoelectric conversion part 22a of the base substrate 22.

The resin spacer 26 surrounding the photoelectric conversion part 22a of the base substrate 22 is a spacer made of a resin formed using the above-described film for a resin spacer 10 (see Figure 1).

In addition, the transparent substrate 24 disposed opposite to the base substrate 22 is made of, for example, an acrylic resin, a polyethylene terephthalate resin (PET), or glass.

The light-receiving device 20 having such a configuration as described above can be used as a solid-state image pickup device. In this case, light entering the light-receiving device 20 through the transparent substrate 24 is received by the light-receiving part 28 and converted into an electrical signal at the photoelectric conversion part 22a of the base substrate 22. Then, the electrical signal converted from the light at the photoelectric conversion part 22a is converted into image data by means of predetermined signal processing.

For the reasons described below, the above-described light-receiving device 20 is less liable to imaging failure resulting from dew condensation due to the characteristics of the film for a resin spacer 10 used to form the resin spacer 26.

As has been already described, the film for a resin spacer 10 is adapted so that the moisture permeation rate of the film's adhesive layer after exposure and heat curing is 12 g/m²/24 h or higher. Accordingly, if humidity is higher inside the hollow package of the light-receiving device 20 than outside the hollow package, moisture within the hollow package is drained through the resin spacer 26. Thus, dew condensation is prevented from occurring within the hollow package of the light-receiving device 20.

Although an example is shown in Figure 2 in which the light-receiving part 28 made of a microlens array is formed only on the photoelectric conversion part 22a of the base substrate 22, the present invention is not limited to this configuration. Alternatively, the microlens array may be formed across the entire surface of the base substrate 22.

Figure 3 is a cross-sectional view illustrating a structural example a light-receiving device in which a microlens array is formed across the entire surface of the base substrate. As illustrated in the figure, a microlens array 29 is formed across the entire surface of the base substrate 22. Only a region of the microlens array 29 surrounded by the resin spacer 26 functions as a light-receiving part. Note that the rest of the configuration is the same as the structural example of the light-receiving device illustrated in Figure 2 and, therefore, will not be described again here.

### (Method for Manufacturing Light-receiving Device)

Next, a description will be given of a method for manufacturing a light-receiving device having the above-described configuration.

Figure 4 is a process drawing illustrating one example of a method for manufacturing a light-receiving device according to the present invention.

First, as illustrated in Figure 4(a), a microlens array 29 is formed on a surface of a silicon wafer 30 in which a plurality of photoelectric conversion parts 22a is formed.

In the figure, an example is shown in which the microlens array 29 is formed across the entire surface of the silicon wafer 30. Alternatively, the microlens array 29 may be selectively formed only on the photoelectric conversion part 22a of the silicon wafer 30.

In addition to the formation of the microlens array 29, the above-described film for a resin spacer 10 is previously cut in conformity to the shape of silicon wafer 30.

The film for a resin spacer 10 can be cut by an optional method. For example, as illustrated in Figure 5A, the film for a resin spacer 10 may be placed on a film contact part 100b of a cutting table 100, and then cut by a cutter 104 provided in an opening of the cutting table 100. At this time, the film for a resin spacer 10 may be cut with the film held down from the cover film 14 side by using a cutting aid member 106, from the viewpoint of preventing flexure in the film for a resin spacer 10 when the film is cut.

Here, the film for a resin spacer 10 is preferably kept to a half-cut state, i.e., a state in which the film is cut to a depth approximately half the thickness of the cover film 14 by adjusting the amount of stab by the cutter 104. Consequently, by conveying the film for a resin spacer 10 as a whole in a direction shown by an arrow A, as illustrated in Figure 5B, it is possible to easily move a half-cut portion of the film for a resin spacer 10 to the position of a silicon wafer 30 which is a substrate to be laminated. The film for a resin spacer 10 is conveyed with the film separated from the film contact part 100b by moving the cutting aid member 106 upwardly (in a direction shown by an arrow B in Figure 5B). After the film for a resin spacer 10 is conveyed, the cutting aid member 106 is moved downwardly (in a direction opposite to the direction of the arrow B) to revert to the condition illustrated in Figure 5A and repeat the cutting of the film for a resin spacer 10.

Note that the film for a resin spacer 10 is such that an adhesion force C₁ between an adhesive layer 12 and the cover film 14 and an adhesion force D between the adhesive layer 12 and a silicone resin are set so as to satisfy the condition C₁ > D. Consequently, it is possible to reduce adherence of a resin composition to the film contact part 100b at the time of the above-described film cutting.

Next, as illustrated in Figure 4(b), the film for a resin spacer 10 cut in conformity to the shape of the silicon wafer 30 is laminated on the microlens array 29 formed on the silicon wafer 30.

Then, the adhesive layer 12 of the film for a resin spacer 10 is exposed and developed to form a resin spacer 26 surrounding the photoelectric conversion part 22a on the microlens 29, as illustrated in Figure 4(c). The exposure and development treatments of the adhesive layer 12 are specifically performed in the following manner.

First, radiant rays (for example, ultraviolet light) are selectively irradiated to the adhesive layer 12 of the film for a resin spacer 10 through a photomask. Consequently, only a portion of the adhesive layer 12 irradiated with radiant rays is light-cured. Thereafter, the cover film 14 is peeled off from the adhesive layer 12. The adhesive layer 12 is developed using a developing fluid, such as an alkaline water solution, to remove unexposed portions (portions not irradiated with radiant rays) of the adhesive layer 12. In this way, the resin spacer 26 surrounding the photoelectric conversion parts 22a is formed as illustrated in, for example, Figure 6.

Next, as illustrated in Figure 4(d), a transparent substrate 24 is bonded to the silicon wafer 30 through the resin spacer 26. The transparent substrate 24 and the silicon wafer 30 may be bonded to each other only by heating or pressurization or by both heating and pressurization.

Thereafter, the silicon wafer 30 is diced from a side opposite to the transparent substrate 24 side, as illustrated in Figure 4(e), to form a groove 32 in a position corresponding to each resin spacer 26.

Note that while the silicon wafer 30 is being diced, heat is generated due to friction between a dicing saw and the silicon wafer 30. Accordingly, dicing is preferably performed while feeding water.

Finally, incisions are made by the dicing saw from the transparent substrate 24 side to divide the silicon wafer 30 and the transparent substrate 24 in units of photoelectric conversion parts 22a. Thus, there are obtained light-receiving devices 20 illustrated in Figure 4(f).

Note that though not illustrated, an electrical insulating layer, such as a silicon oxide film, is formed and a metal film is formed by means of sputtering or the like on side surfaces of each groove 32 and on a bottom face of the silicon wafer 30 after the dicing of the silicon wafer 30. This metal film functions as a signal transmission path for transferring an electrical signal output from each photoelectric conversion part 22a to the external substrate side when each light-receiving device 20 is mounted on an external substrate through solder bumps or the like.

Also note that though an example is shown in Figure 4 in which the resin spacer 26 is formed on the silicon wafer 30 side, the present invention is not limited to this configuration. Alternatively, the resin spacer 26 may be formed on the transparent substrate 24 side. In this case, the film for a resin spacer 10 is first laminated on the transparent substrate 24, and is then subjected to exposure and development treatments, thereby forming the resin spacer 26 on the transparent substrate 24. Then, the transparent substrate 24 and the silicon wafer 30 are bonded to each other through the resin spacer 26, with the transparent substrate 24 and the silicon wafer 30 aligned with each other so that the photoelectric conversion parts 22a of the silicon wafer 30 are surrounded by the resin spacer 26. Finally, the transparent substrate 24 and the silicon wafer 30 bonded to each other through the resin spacer 26 are divided in units of photoelectric conversion parts 22a by the same methods as those illustrated in Figures 4(e) and 4(f).

### (MEMS Device)

Next, a description will be given of a MEMS device manufactured using the above-described film for a resin spacer.

Figure 7 is a cross-sectional view illustrating a structural example of a MEMS device according to the present invention.

As illustrated in the figure, a MEMS device 40 is comprised mainly of a base substrate 44 in which a functional part 42 is formed; a cover substrate 46 disposed so as to face the base substrate 44; and a resin spacer 26 disposed between the base substrate 44 and the cover substrate 46, so as to surround the functional part 42.

The base substrate 44 is made of monocrystalline silicon or the like, and a functional part 42 including MEMS elements, such as a pressure sensor and an acceleration sensor, is formed on the base substrate 44.

The resin spacer 26 surrounding the functional part 42 on the base substrate 44 is a spacer made of a resin formed using the above-described film for a resin spacer 10 (see Figure 1).

In addition, the cover substrate 46 facing the base substrate 44 is made of, for example, an acrylic resin, a polyethylene terephthalate resin (PET), glass, or monocrystalline silicon.

Note that in the example illustrated in Figure 7, a description has been given of a MEMS device having a hollow package structure in which the functional part 42 including MEMS elements is surrounded by the resin spacer 26. The present invention is not limited to this MEMS device, however. Alternatively, the present invention may be applied to various other MEMS devices including a resin spacers, such as a printer head, an optical scanner, and a flow path module.

### (Method for Manufacturing MEMS Device)

Next, a description will be given of a method for manufacturing a MEMS device having the above-described configuration.

Figure 8 is a process drawing illustrating one example of a method for manufacturing a MEMS device according to the present invention.

First, there is prepared a silicon wafer 50 in which a plurality of functional parts 42 including a MEMS element is formed, as illustrated in Figure 8(a). In addition, the above-described film for a resin spacer 10 is previously cut in conformity to the shape of the silicon wafer 50. The film for a resin spacer 10 may be cut using the same method as used in the already-described method for manufacturing a light-receiving device.

Next, as illustrated in Figure 8(b), the film for a resin spacer 10 cut in conformity to the shape of the silicon wafer 50 is laminated thereon.

Then, the adhesive layer 12 of the film for a resin spacer 10 is exposed and developed to form the resin spacer 26 surrounding the functional part 42 on the silicon wafer 50, as illustrated in Figure 8(c). The exposure and development treatments of the adhesive layer 12 may be performed using the same method as used in the already-described method for manufacturing a light-receiving device.

Next, as illustrated in Figure 8(d), a cover substrate 46 is bonded to the silicon wafer 50 through the resin spacer 26. The cover substrate 46 and the silicon wafer 50 may be bonded to each other only by heating or pressurization or by both heating and pressurization.

Thereafter, the silicon wafer 50 is diced from a side opposite to the cover substrate 46 side, as illustrated in Figure 8(e), to form a groove 52 in a position corresponding to each resin spacer 26.

Note that while the silicon wafer 50 is being diced, heat is generated due to friction between a dicing saw and the silicon wafer 50. Accordingly, dicing is preferably performed while feeding water.

Finally, incisions are made by the dicing saw from the cover substrate 46 side to divide the silicon wafer 50 and the cover substrate 46 in units of functional parts 42. Thus, there are obtained MEMS devices 40 illustrated in Figure 8(f).

Note that though an example is shown in Figure 8 in which the resin spacer 26 is formed on the silicon wafer 50 side, the present invention is not limited to this configuration. Alternatively, the resin spacer 26 may be formed on the cover substrate 46 side. In this case, the film for a resin spacer 10 is first laminated on the cover substrate 46, and is then subjected to exposure and development treatments, thereby forming the resin spacer 26 on the cover substrate 46. Then, the cover substrate 46 and the silicon wafer 50 are bonded to each other through the resin spacer 26, with the cover substrate 46 and the silicon wafer 50 aligned with each other so that the functional part 42 on the silicon wafer 50 is surrounded by the resin spacer 26. Finally, the cover substrate 46 and the silicon wafer 50 bonded to each other through the resin spacer 26 are divided in units of functional parts 42 by the same methods as those illustrated in Figures 8(e) and 8(f).

### {Examples}

Hereinafter, the present invention will be described in detail according to practical and comparative examples, though the invention is not limited to these examples.

### (Practical Example 1)

### 1. Synthesis of Alkali-soluble Resin (Methacryloyl Modified Novolac-type Bisphenol-A Resin)

500 g of a MEK (methyl ethyl ketone) solution with a 60% solid content of a novolac-type bisphenol-A resin (PHENOLITE LF-4871 made by Dainippon Ink and Chemicals, Incorporated) was poured into a 2L flask. 1.5 g of tributylamine and 0.15 g of hydroquinone were added to this solution as a catalyst and a polymerization inhibitor, respectively. The solution was warmed to 100°C. 180.9 g of glycidyl methacrylate was dropped into the solution in 30 minutes, and the solution was agitated and reacted at 100°C for 5 hours. Thus, there was obtained a methacryloyl modified novolac-type bisphenol-A resin MPN001 (methacryloyl modification ratio of 50%) with a 74% solid content.

### 2. Preparation of Resin Varnish

There were weighed 60 wt. % of the above-described methacryloyl modified novolac-type bisphenol-A resin MPN001 (MPN001) as an alkali-soluble resin, 10 wt.% of a bisphenol-A type epoxy resin (EP-1001 made by Japan Epoxy Resin Co., Ltd.) and 5 wt.% of a cresol novolac-type epoxy resin (EOCN-1020-70 made by Nippon Kayaku Co., Ltd.) as a thermosetting resin and an epoxy resin, 5 wt. % of epoxy ester (Epoxy Ester 3002M made by KYOEISHA CHEMICAL Co., LTD.) as a photopolymerizable resin, 15 wt.% of trimethylolpropane trimethacrylate (LIGHT-ESTER TMP made by KYOEISHA CHEMICAL Co., LTD.), 2 wt. % of a photopolymerization initiator (IRGACURE 651 made by Ciba Specialty Chemicals Corporation), and 3 wt. % of a phenol novolac resin (PR53647 made by Sumitomo Bakelite Company, Limited). Using a disperser, these materials were agitated at a revolution speed of 3000 rpm for one hour, thereby preparing resin varnish.

### 3. Fabrication of Film for Resin Spacer

The resin varnish was coated on a polyester film (MRX50, 50 µm in thickness, made by Mitsubishi Plastics, Inc.) serving as a supporting base material by using a comma coater, and dried at 80°C for 20 minutes. Thus, there was obtained a film for a resin spacer having a 50 µm-thick adhesive layer.

### (Practical Example 2)

Practical Example 2 was the same as Practical Example 1, except that the composition of the resin varnish in Practical Example 1 was set as described below. The ingredient amount of trimethylolpropane trimethacrylate was set to 20 wt. % , the ingredient amount of bisphenol-A type epoxy resin was set to 20 wt.%, and the ingredient amount of (meth)acrylic modified bis-A novolac resin was set to 45 wt.%.

### (Practical Example 3)

Practical Example 3 was the same as Practical Example 1, except that the composition of the resin varnish in Practical Example 1 was set as described below. The ingredient amount of trimethylolpropane trimethacrylate was set to 20 wt. % , the ingredient amount of bisphenol-A type epoxy resin was set to 25 wt. % , and the ingredient amount of (meth)acrylic modified bis-A novolac resin was set to 40 wt.%.

### (Practical Example 4)

Practical Example 4 was the same as Practical Example 1, except that the composition of the resin varnish in Practical Example 1 was set as described below. The ingredient amount of trimethylolpropane trimethacrylate was set to 20 wt. % , the ingredient amount of bisphenol-A type epoxy resin was set to 5 wt. % , the ingredient amount of cresol novolac-type epoxy resin (EOCN-1020-70 made by Nippon Kayaku Co., Ltd.) was set to 20 wt.%, and the ingredient amount of (meth)acrylic modified bis-A novolac resin was set to 45 wt.%.

### (Practical Example 5)

Practical Example 5 was the same as Practical Example 1, except that the composition of the resin varnish in Practical Example 1 was set as described below. The ingredient amount of epoxy ester (Epoxy Ester 3002M made by KYOEISHA CHEMICAL Co., LTD.) was set to 1 wt.%, the ingredient amount of trimethylolpropane trimethacrylate was set to 5 wt.%, the ingredient amount of bisphenol-A type epoxy resin was set to 8 wt. % , the ingredient amount of cresol novolac-type epoxy resin (EOCN-1020-70 made by Nippon Kayaku Co., Ltd.) was set to 25 wt.%, and the ingredient amount of (meth)acrylic modified bis-A novolac resin was set to 56 wt.%.

### (Comparative Example 1)

Comparative Example 1 in which the ingredient amount of resin varnish was varied was set, in addition to the practical examples described above.

The table of Figure 9 shows the ingredient amounts of films for a resin spacer in Practical Examples 1 to 5 and Comparative Example 1.

### (Evaluation of Films for Resin Spacer)

Using the films for a resin spacer obtained as described above, evaluations were made on resin adherability at the time of film cutting, provisional fixability to a substrate to be laminated, and the detachability of a cover film.

### (1) Measurement of Adhesion Forces

The films for a resin spacer obtained in Practical Examples 1 to 5 and Comparative Example 1 were cut to a width of 18 mm. The cover film side of each film was fixed to a glass epoxy substrate with a double-sided adhesive tape. In addition, Sellotape (R) (18 mm-wide tape made by Mitsubishi Uni) was tightly laminated on the adhesive layer of each film by using a rubber roller, so as not to let in air bubbles. The Sellotape (R) was pulled with a tensile testing machine in a 180° direction under the pulling rate condition of 1000 mm/min to measure an adhesion force C₁ (N/m). The table of Figure 10 shows measurement results.

Likewise, the films for a resin spacer obtained in Practical Examples 1 to 5 and Comparative Example 1 were cut to a width of 18 mm. The cover film side of each film was fixed to a glass epoxy substrate with a double-sided adhesive tape. Thereafter, each film was exposed on the cumulative light exposure condition of 700 mJ/cm² by using light of a 365 nm wavelength. In addition, Sellotape (R) (18 mm-wide tape made by Mitsubishi Uni) was tightly laminated on the adhesive layer of each film by using a rubber roller, so as not to let in air bubbles. The Sellotape (R) was pulled with a tensile testing machine in a 180° direction under the pulling rate condition of 1000 mm/min to measure an adhesion force C₂ (N/m). The table of Figure 10 shows measurement results.

In addition, the films for a resin spacer obtained in Practical Examples 1 to 5 and Comparative Example 1 were cut to a width of 36 mm. The adhesive layer side of each film was overlapped on a silicone resin sheet (composite functional silicone sheet made by Nippa Co., Ltd.). Under this condition, the adhesive layer side of each film for a resin spacer was laminated on the silicone resin sheet by taking advantage of the self weight of a rubber roller (roll weight: 400 g, roll width: 16.5 cm). A silicone resin sheet with an adhesive layer obtained in this way was specified as an evaluation sample used to measure an adhesion force D between an adhesive layer and a silicone resin before exposure. The base material of the evaluation sample thus prepared was pulled with a tensile testing machine in a 180° direction under the pulling rate condition of 1000 mm/min to measure the adhesion force D (N/m). The table of Figure 10 shows measurement results.

The films for a resin spacer obtained in Practical Examples 1 to 5 and Comparative Example 1 were respectively laminated on an 8-inch silicon wafer (part number: PW, 725 µm in thickness, made by SUMCO Corporation) by using a roll laminator (roll temperature: 60°C, rolling rate: 0.3 m/min, syringe pressure: 2.0 kgf/cm²). A silicon wafer with an adhesive layer obtained in this way was specified as an evaluation sample used to measure an adhesion force E₁ between the adhesive layer and the silicon wafer before exposure.

In addition, a sample obtained by exposing the above-described silicon wafer with an adhesive layer on the cumulative light exposure condition of 700 mJ/cm² by using light of a 365 nm wavelength was specified as an evaluation sample used to measure an adhesion force E₂ between the adhesive layer and the silicon wafer after exposure.

Then, Sellotape (R) (18 mm-wide tape made by Mitsubishi Uni) was tightly attached to the adhesive layer of the above-described prepared evaluation sample by using a rubber roller, so as not to let in air bubbles. An 18 mm-wide incision was made in the adhesive layer. The Sellotape (R) was pulled with a tensile testing machine in a 180° direction under the pulling rate condition of 1000 mm/min to measure the adhesion forces E₁ (N/m) and E₂ (N/m). The table of Figure 10 shows measurement results.

### (2) Resin Adherability at the Time of Film Cutting

The films for a resin spacer obtained in Practical Examples 1 to 5 and Comparative Example 1 were cut to a shape 1 mm smaller than the diameter of the silicon wafer by using a film laminator (Team 100 made by Takatori Corporation). After film cutting, a cutting stage was visually observed to evaluate resin adherability to the cutting stage according to the below-described criteria. The table of Figure 10 shows evaluation results.

Acceptable: No visually observable resin deposits are present on the cutting stage.

Defective: Visually observable resin deposits are present on the cutting stage.

### (3) Provisional Fixability to Substrate to be Laminated

The films for a resin spacer obtained in Practical Examples 1 to 5 and Comparative Example 1 were respectively laminated on an 8-inch silicon wafer (part number: PW, 725 µm in thickness, made by SUMCO Corporation) by using a roll laminator (roll temperature: 60°C, rolling rate: 0.3 m/min, syringe pressure: 2.0 kgf/cm²).

The silicon wafer on which a film for a resin spacer was laminated was visually observed to evaluate provisional fixability to a substrate to be laminated according to the below-described criteria. The table of Figure 10 shows evaluation results.

Acceptable: The film is not peeled off across the entire surface of the silicon wafer.

Defective: The film is partially peeled off at an end face of the silicon wafer.

### (4) Detachability of Cover Film

The films for a resin spacer obtained in Practical Examples 1 to 5 and Comparative Example 1 were respectively laminated on a silicon wafer (part number: PW, 725 µm in thickness, made by SUMCO Corporation) by using a roll laminator (roll temperature: 60°C, rolling rate: 0.3 m/min, syringe pressure: 2.0 kgf/cm²). Subsequently, exposure using light of a 365 nm wavelength was performed on the film for a resin spacer on the silicon wafer on the cumulative light exposure condition of 700 mJ/cm². Thereafter, the cover film was peeled off from the adhesive layer.

The cover film peeled off from the adhesive layer was visually observed to evaluate the detachability of the cover film according to the below-described criteria. The table of Figure 10 shows evaluation results.

Acceptable: No visually observable resin deposits are present on the cover film, and neither lift nor delamination is observed in the adhesive layer on the silicon wafer.

Defective: Visually observable resin deposits are present on the cover film, and either lift or delamination is observed in the adhesive layer on the silicon wafer.

As is understood from the table of Figure 10, resin adherence to the cutting stage did not occur in Practical Examples 1 to 5 in which the adhesion forces C₁ and D satisfied the condition C₁ > D. In addition, if the adhesion force E₁ satisfied the condition E₁ > 200 N/m, it was possible to provisionally fix each film for a resin spacer onto the silicon wafer in a reliable manner. In addition, if the adhesion forces C₂ and E₂ satisfied the condition C₂ < E₂, resin adherence to the cover film did not occur when the cover film was peeled off.

In contrast, resin adherence to the cutting stage occurred in Comparative Example 1 in which the adhesion forces C₁ and D did not satisfy the condition C₁ > D.

### (Evaluation of Resin Spacer Characteristics)

For the above-described films for a resin spacer, resin spacer characteristics were evaluated as described below.

### (1) Elastic Modulus

Exposure using light of a 365 nm wavelength was performed on the films for a resin spacer obtained in Practical Examples 1 to 5 and Comparative Example 1 on the cumulative light exposure condition of 700 mJ/cm². Subsequently, a cover film was peeled off from the adhesive layer of each film for a resin spacer. Three adhesive layers were stacked to measure a storage elastic modulus G' with a dynamic viscoelasticity measuring apparatus Rheo Stress RS 150 (made by HAAKE; measuring frequency: 1 Hz, gap pitch: 100 µm, measurement temperature range: 25 to 200°C, rate of temperature rise: 10°C/min), thereby determining an elastic modulus at 80°C. The table of Figure 11 shows measurement results.

### (2) Moisture Permeation Rate

Using a laminator set at 60°C, films for a resin spacer were bonded to fabricate a 100 µm-thick adhesive layer. The adhesive layer was exposed on the cumulative light exposure condition of 700 mJ/cm² by using light of a 365 nm wavelength. Thereafter, the adhesive layer was heat-cured on the condition of 180°C/2 hours. The exposed and heat-cured adhesive layer thus obtained was evaluated in compliance with the water vapor permeability cup method (JIS Z0208) under the ambient condition of 40°C/90%, thereby measuring a moisture permeation rate. The table of Figure 11 shows measurement results.

### (3) Resin Spacer Characteristics

An evaluation sample for evaluating resin spacer characteristics was fabricated according to the following procedure.

A film for a resin spacer was laminated on an 8-inch silicon wafer (base substrate) (part number: PW, 725 µm in thickness, made by SUMCO Corporation) by using a roll laminator (roll temperature: 60°C, rolling rate: 0.3 m/min, syringe pressure: 2.0 kgf/cm²), thereby obtaining a silicon wafer with a film for a resin spacer. Next, a mask of an exposure apparatus and the above-described silicon wafer were aligned with each other by using light of a 600 nm wavelength. Next, the film was exposed on the cumulative light exposure condition of 700 mJ/cm² by using light of a 365 nm wavelength. Thereafter, the cover film was peeled off from the adhesive layer. In addition, the adhesive layer was subjected to a development treatment (pressure: 0.3 MPa, time: 90 sec) using a 2.38% TMAH (tetramethylammonium hydroxide) to form a 0.6 mm-wide resin spacer having a 5 mm square opening.

Next, the above-described silicon wafer in which the resin spacer was formed and an 8-inch transparent substrate were set on a substrate bonder (SB8e made by SÜSS MicroTec AG.) to pressure-bond the silicon wafer and the 8-inch transparent substrate. In addition, the bonded wafer and substrate were post-cured on the condition of 150°C, 90 minutes. A bonded product of the silicon wafer and the 8-inch transparent substrate thus obtained was diced to a predetermined size by using a dicing saw to obtain a light-receiving device as an evaluation sample.

The resin spacer of the above-described evaluation sample was visually observed to evaluate the flowability (degree of collapse) of the resin spacer according to the below-described criteria. The table of Figure 11 shows evaluation results.

Acceptable: No changes are observed in the dimensions of the resin spacer before and after thermocompression bonding.

Defective: The resin spacer after thermocompression bonding flows to a large degree, thus resulting in significant variations in both dimensions and shape.

Next, the above-described evaluation sample was allowed to stand for 168 hours under the temperature and humidity conditions of 85°C and 85%, and then exposed to the ambient temperature and humidity conditions of 25°C and 50%. The inside of a hollow package of the evaluation sample was observed with a microscope. Then, evaluations were made, according to the below-described criteria, as to whether or not dew condensation was present inside the hollow package. The table of Figure 11 shows evaluation results.

Acceptable: No dew condensation is present inside the hollow package.

Defective: Dew condensation is present inside the hollow package.

In addition, the above-described evaluation sample was allowed to stand for 168 hours under the temperature and humidity conditions of 85°C and 85%, and then subjected to a 260°C solder reflow process three times. Thereafter, the evaluation sample was observed with a microscope. Then, evaluations were made, according to the below-described criteria, on the reliability of the evaluation sample as a light-receiving device.

Acceptable: Neither delamination nor chip cracks are present.

Defective: Either delamination or chip cracks are present.

As is understood from the table of Figure 11, any shape variations in the resin spacer did not occur at the time of pressure-bonding the transparent substrate, if the elastic modulus of the adhesive layer after exposure was 100 Pa or higher. In addition, any dew condensation did not occur inside the hollow package if the moisture permeation rate of the adhesive layer after exposure and heat curing was 12 g/m²/24 h or higher. Yet additionally, it has been found that a light-receiving device superior in reliability can be obtained using the films for a resin spacer of Practical Examples 1 to 5.

In contrast, shape variations in the resin spacer occurred at the time of pressure-bonding the transparent substrate in Comparative Example 1 in which the elastic modulus of the adhesive layer after exposure was 80 Pa.

### {Reference Signs List}

10: Film for a resin spacer, 12: Adhesive layer, 14: Cover film, 20: Light-receiving device, 22: Base substrate, 22a: Photoelectric conversion part, 24: Transparent substrate, 26: Resin spacer, 28: Light-receiving part, 29: Microlens array, 30: Silicon wafer, 32: Groove, 40: MEMS device, 42: Functional part, 44: Base substrate, 46: Cover substrate, 50: Silicon wafer, 52: Groove, 100: Cutting table, 100a: Stage section, 100b: Film contact part, 102: Film for a resin spacer, 104: Cutter, 106: Cutting aid member

## Claims

1. A film for a resin spacer, the film including:
an adhesive layer made of a resin composition; and
a cover film covering a surface of the adhesive layer,
wherein an adhesion force C₁ between the adhesive layer and the cover film and an adhesion force D between the adhesive layer and a silicone resin satisfy the condition C₁ > D.

2. The film for a resin spacer according to claim 1, wherein an adhesion force E₁ between the adhesive layer and a silicon wafer satisfies the condition E₁ > 0.01 N/m.

3. The film for a resin spacer according to claim 1 or 2, wherein an adhesion force C₂ between the adhesive layer and the cover film after exposure on the i-line based cumulative light exposure condition of 700 mJ/cm² and an adhesion force E₂ between the adhesive layer and the silicon wafer after exposure on the i-line based cumulative light exposure condition of 700 mJ/cm² satisfy the condition C₂ < E₂.

4. The film for a resin spacer according to any one of claims 1 to 3, wherein the elastic modulus of the adhesive layer after exposure on the i-line based cumulative light exposure condition of 700 mJ/cm² is 100 Pa or higher at a measurement temperature of 80°C.

5. The film for a resin spacer according to any one of claims 1 to 4, wherein the moisture permeation rate of the adhesive layer after exposure on the i-line based cumulative light exposure condition of 700 mJ/cm² and heat curing on the condition of 180°C and 2 hours measured by a JIS Z0208 B method is 12 g/m²/24 h or higher.

6. The film for a resin spacer according to any one of claims 1 to 5, wherein the resin composition contains an alkali-soluble resin and a photopolymerizable resin.

7. The film for a resin spacer according to claim 6, wherein the resin composition further contains a thermosetting resin.

8. The film for a resin spacer according to claim 6 or 7, wherein the alkali-soluble resin contains a (meth)acrylic modified novolac resin.

9. The film for a resin spacer according to any one of claims 6 to 8, wherein the alkali-soluble resin contains a carboxyl group-containing polymer selected from the group consisting of a carboxyl group-containing epoxy acrylate, a carboxyl group-containing acrylic polymer, and polyamide acid.

10. The film for a resin spacer according to any one of claims 6 to 9, wherein the photopolymerizable resin contains an acrylic monomer.

11. The film for a resin spacer according to claim 10, wherein the acrylic monomer is one of a trifunctional (meth)acrylate compound and a tetrafunctional (meth)acrylate compound.

12. The film for a resin spacer according to any one of claims 6 to 11, wherein the photopolymerizable resin contains a (meth)acrylic acid adduct of an epoxy compound.

13. A light-receiving device including:
a base substrate in which a photoelectric conversion part is formed;
a transparent substrate disposed so as to face the base substrate; and
a resin spacer disposed between the base substrate and the transparent substrate so as to surround the photoelectric conversion part,
wherein the resin spacer is formed of a film for a resin spacer according to any one of claims 1 to 12.

14. A MEMS device including:
a base substrate in which a functional part including a MEMS element is formed;
a cover substrate disposed so as to face the base substrate; and
a resin spacer disposed between the base substrate and the cover substrate so as to surround the functional part,
wherein the resin spacer is formed of a film for a resin spacer according to any one of claims 1 to 12.

15. A method for manufacturing a light-receiving device, the method including:
a film cutting step of cutting a film for a resin spacer according to any one of claims 1 to 12;
a laminating step of laminating the film for a resin spacer cut in the film cutting step on a surface of a wafer in which a plurality of photoelectric conversion parts is formed;
an exposure/development step of exposing and developing the film for a resin spacer laminated on the wafer, so that a resin spacer surrounding the plurality of photoelectric conversion parts is formed;
a bonding step of bonding the wafer and the transparent substrate through the resin spacer formed in the exposure/development step; and
a dividing step of dividing the wafer and the transparent substrate bonded through the resin spacer in units of photoelectric conversion parts.

16. A method for manufacturing a light-receiving device, the method including:
a film cutting step of cutting a film for a resin spacer according to any one of claims 1 o 12;
a laminating step of laminating the film for a resin spacer cut in the film cutting step on a surface of a transparent substrate;
an exposure/development step of exposing and developing the film for a resin spacer laminated on the transparent substrate, so that a resin spacer is formed on the transparent substrate;
a bonding step of bonding a wafer in which a plurality of photoelectric conversion parts is formed and the transparent substrate through the resin spacer formed in the exposure/development step, so that the plurality of photoelectric conversion parts is surrounded by the resin spacer; and
a dividing step of dividing the wafer and the transparent substrate bonded through the resin spacer in units of photoelectric conversion parts.

17. A method for manufacturing a MEMS device, the method including:
a film cutting step of cutting a film for a resin spacer according to any one of claims 1 to 12;
a laminating step of laminating the film for a resin spacer cut in the film cutting step on a surface of a wafer in which a functional part including a MEMS element is formed;
an exposure/development step of exposing and developing the film for a resin spacer laminated on the wafer, so that a resin spacer surrounding the functional part is formed; and
a bonding step of bonding the wafer and a cover substrate through the resin spacer formed in the exposure/development step.

18. A method for manufacturing a MEMS device, the method including:
a film cutting step of cutting a film for a resin spacer according to any one of claims 1 to 12;
a laminating step of laminating the film for a resin spacer cut in the film cutting step on a surface of a cover substrate;
an exposure/development step of exposing and developing the film for a resin spacer laminated on the cover substrate, so that a resin spacer is formed on the cover substrate;
and
a bonding step of bonding a wafer in which a functional part including a MEMS element is formed and the cover substrate through the resin spacer formed in the exposure/development step, so that the functional part is surrounded by the resin spacer.
